# FASCICULE DE BREVET EUROPEEN

(11) **EP 0 551 029 B1**
(45) Date de publication et mention de la délivrance du brevet: **16.10.1996**
(21) Numéro de dépôt: 92403221.2
(22) Date de dépôt: 27.11.1992
(51) Int. Cl.: G01R 19/00, G01R 19/18, H02M 7/537

(54) **Dispositif de conversion d'un signal de tension continue de très faible amplitude en signal de tension alternative**
Vorrichtung zur Umwandlung eines sehr kleinen Gleichspannungssignals in ein Wechselspannungssignal
Device for converting a very low amplitude DC signal in an AC signal

(30) Priorité: 07.01.1992 FR 9200083
(43) Date de publication de la demande: 14.07.1993
(73) Titulaire: FRAMATOME, 92400 Courbevoie (FR); CENTRE NATIONAL DE LA RECHERCHE SCIENTIFIQUE, 75007 Paris (FR)
(72) Inventeur: Chaussy, Jacques, F-38130 Echirolles (FR); Bret, Jean-Louis, F-38180 Seyssins (FR); Picot, Bernard, F-38320 Brie et Angonnes (FR); Meyer, Jacques, F-78500 Sartrouville (FR)
(74) Mandataire: Habasque, Etienne Joel Jean-François

(56) Documents cités:
- FR-A- 2 329 077
- 15TH EUROPEAN MICROWAVE CONFERENCE PROCEEDINGS Septembre 1985, PARIS pages 477 - 482 MCGRATH, R[IS[NEN & RICHARDS 'Accurate noise measurements of cryogenic microwave amplifiers and mixers using variable-temperature loads'
- IBM JOURNAL OF RESEARCH AND DEVELOPMENT vol. 26, no. 3, Mai 1982, pages 372 - 378, HOWARD: 'Optimization of Idium-Lead Alloys for Controlled Collapse Chip Connection Application'
- CRYOGENICS vol. 16, no. 10, Octobre 1976, pages 583 - 586 TIEN & CUNNINGTON 'Glass microsphere cryogenic insulation'

## Description

La présente invention concerne un dispositif de conversion d'un signal de tension continue de très faible amplitude en signal de tension alternative.

Plus particulièrement, ce dispositif est utilisé par exemple dans des dispositifs de mesure de tension de l'ordre de 10⁻¹⁰ volt.

Pour amplifier de telles tensions continues ou lentement variables, il est fréquemment fait appel à des dispositifs connus sous le nom de hâcheurs dont l'objet est de découper ladite tension continue ou lentement variable en une succession d'impulsions de largeur constante et de hauteur représentative de l'amplitude de la tension continue ou lentement variable.

L'amplification du signal impulsionnel résultant s'apparente ensuite à l'amplification d'un signal alternatif, l'amplification de ce type de signal étant généralement plus facile à réaliser que celle d'un signal continu ou lentement variable.

Les premiers dispositifs hâcheurs qui ont été réalisés, utilisaient des composants électromécaniques, généralement appelés vibreurs et constitués de contacts fermés ou ouverts par l'action d'un électro-aimant alimenté en courant alternatif sinusoïdal ou rectangulaire.

Il fut ensuite fait appel à des moyens électroniques de commutation, tubes, transistors classiques, transistors à effet de champ (FET), combinés ou non avec des moyens de commande optiques, photodiodes, phototransistors, photorésistances, et éventuellement à ces seuls dispositifs photosensibles (voir par exemple le document FR-A-2 329 077).

Ces évolutions technologiques ont permis de réduire progressivement le bruit propre aux dispositifs de commutation eux-mêmes, ainsi que le signal parasite induit par le signal de commande (couplage optique) autorisant ainsi la mesure de signaux de très faibles amplitudes, de l'ordre du microvolt, voire de la fraction de microvolt.

Cependant, pour atteindre des sensibilités encore plus grandes, il est impératif de faire travailler les dispositifs de commutation à basse et même à très basse température, de manière à réduire de manière significative les bruits de toute provenance (électronique, thermo-électronique, thermique).

En utilisant comme source de réfrigération de cet ensemble, de l'azote liquide, dont la température d'ébullition est de 77°K, il a été possible de descendre au nanovolt et même un peu au-dessous.

Cependant, l'idéal serait de pouvoir se placer à des températures voisines du zéro absolu, par exemple à 4,2°K, température d'ébullition de l'hélium liquide. A ce niveau de température, les différents bruits évoqués précédemment deviennent quasi-négligeables, mais il apparaît alors un problème difficile à résoudre.

En effet, les meilleurs transistors, et par exemple les meilleurs transistors à effet de champ, sélectionnés pour fonctionner à 77°K, ne fonctionnent pas du tout à cette température car les porteurs de charge (électrons et trous) ont perdu toute mobilité.

Le but de l'invention est donc de résoudre ces problèmes en proposant un dispositif de conversion qui soit simple, fiable et qui puisse fonctionner à de telles températures.

A cet effet, l'invention a pour objet un dispositif de conversion d'un signal de tension continue de très faible amplitude en signal de tension alternative, du type comportant un transformateur à point milieu associé à un hâcheur à transistors, caractérisé en ce que le, transformateur et les transistors sont disposés dans une partie d'un boîtier maintenue à très basse température et dans laquelle est disposé un matériau d'isolation thermique des transistors afin de réduire les fluctuations de température et permettre le fonctionnement de ces transistors par auto-échauffement dû à leur courant de commande.

L'invention sera mieux comprise à l'aide de la description qui va suivre, donnée uniquement à titre d'exemple et faite en se référant aux dessins annexés, sur lesquels :
- la Fig.1 représente un schéma synoptique d'un dispositif de conversion selon l'invention; et
- la Fig.2 représente une vue en coupe d'un boîtier dans lequel est disposé un dispositif de conversion selon l'invention.

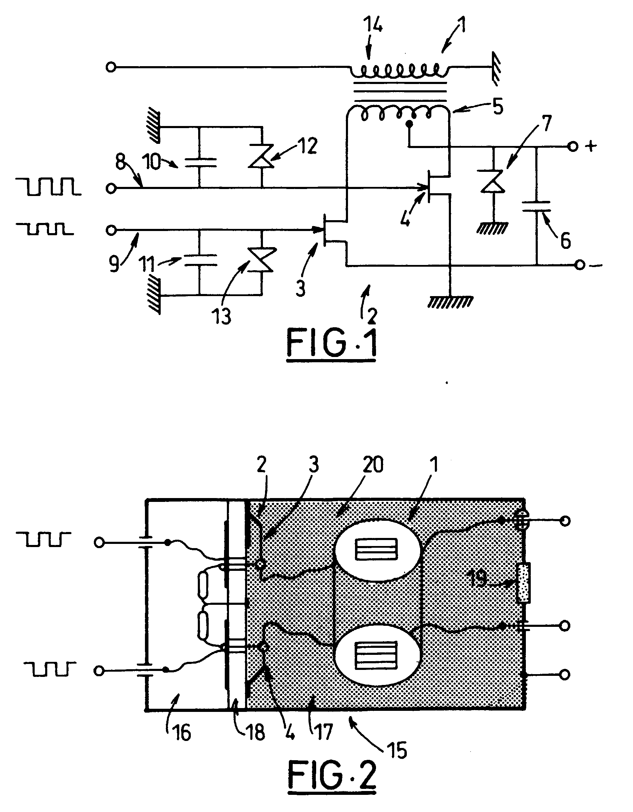

Ainsi qu'on peut le voir sur la Fig.1, qui représente un schéma synoptique d'un dispositif de conversion selon l'invention, celui-ci est basé sur l'utilisation d'un transformateur à point milieu désigné par la référence générale 1 et d'un hâcheur 2 à transistors, désignés par les références 3 et 4.

La borne positive de l'entrée du signal de tension continue qu'il y a lieu de convertir, est reliée au point milieu de l'enroulement correspondant par exemple 5 du transformateur, tandis que chaque extrémité de celuici est relié à un transistor 3,4 correspondant.

Ces transistors sont par exemple des transistors à effet de champ.

Un condensateur de découplage 6 est connecté entre les bornes positive et négative de l'entrée de signal de tension continue et une diode zener 7 de protection contre les surtensions est également raccordée à cette borne positive.

Les grilles des transistors à effet de champ 3 et 4 reçoivent des signaux de commande par des lignes 8 et 9, celles-ci étant découplées par des condensateurs 10 et 11 respectivement et protégées par des diodes zener 12 et 13 respectivement.

Un signal de tension alternative est obtenu aux bornes de l'autre enroulement 14 du transformateur par commande de l'un ou l'autre des transitors, de manière classique.

Ainsi qu'on l'a indiqué précédemment, cette tension alternative est plus facile à mesurer qu'une tension continue.

Comme on peut le voir sur la Fig.2, le transformateur 1 et le hâcheur 2 sont disposés dans un boitier 15 divisé en deux parties 16 et 17 par une cloison de séparation 18.

Le transformateur 1 et les transistors 3 et 4 du hâcheur sont disposés dans la partie 17 de celui-ci, tandis que le reste du circuit est disposé dans la partie 16 de celui-ci.

Ce boitier peut être en matériau conducteur de l'électricité ou supraconducteur constituant dans ce dernier cas une cage de Faraday quasi parfaite.

Les transistors 3 et 4 peuvent être constitués par exemple par des transistors à effet de champ du type NE 72089 commercialisés par la société NEC. Ces transistors à effet de champ sont à arséniure de gallium.

Ces transistors présentent par rapport aux transistors au silicium, un certain nombre d'avantages, parmi lesquels une très faible capacité parasite d'entrée, un très faible courant de fuite de grille et un fonctionnement possible à de plus basses températures.

Le transformateur 1 est quant à lui un transformateur élévateur ou d'adaptation de tension du type torique avec noyau en matériau magnétique, choisi parmi ceux qui présentent une bonne perméabilité dans une large plage de température et qui sont très peu microphoniques (Cryoperm ou Amorphe métallique par exemple).

On constate donc que le dispositif de conversion selon l'invention utilise des composants standards moins coûteux et d'une mise en oeuvre plus commode que les éléments de technologie plus récentes, comme les SQUID (Superconducting Quantum Interference Device) ou les jonctions à effet JOSEPHSON.

L'ensemble hàcheur-transformateur est disposé dans une partie du boitier 15 qui est maintenue à très basse température, par exemple inférieure ou égale à 4,2°K en utilisant par exemple de l'hélium liquide, introduit dans le boîtier à travers un disque de Poral 19. Un matériau d'isolation thermique des transistors 3 et 4 est également disposé dans cette partie du boîtier afin de réduire les fluctuations de température et permettre le fonctionnement de ces transistors par auto-échauffement dû à leur courant de commande.

En effet, on a indiqué précédemment que les transistors ne fonctionnaient pas normalement à de si basses températures. En prévoyant ce matériau d'isolation thermique, on utilise l'énergie dissipée dans chaque transistor par son courant d'alimentation pour porter sa température à une valeur suffisante pour lui permettre de fonctionner normalement alors qu'il se trouve dans un environnement à très basse température.

Dans le cas d'un transistor à effet de champ, l'énergie libérée par le courant de polarisation d'un tel transistor bien que petite, est suffisante pour porter sa température aux environs de 120°K si les transferts thermiques entre source chaude (FET) et source froide (hélium liquide) sont bien contrôlés par le matériau d'isolation.

Ce matériau d'isolation désigné par la référence générale 20 sur la figure 2, peut comprendre des microbilles de verre d'un diamètre de l'ordre de 20 µm. Ces billes permettent également de réduire la microphonie et les disparités de température et de bloquer le transformateur et les fils de connexion de celui-ci en position.

Par ailleurs, des précautions particulières sont également prises pour éliminer le bruit thermoélectrique engendré au niveau des soudures assurant la continuité des liaisons électriques entre les différents composants du circuit.

Les alliages étain-plomb habituellement utilisés présentent en effet deux défauts, à savoir une grande fragilité aux chocs thermiques et un bruit thermo-électrique incompatible avec le niveau de résolution recherché.

Pour réaliser ces soudures on a utilisé un alliage indium/plomb dans des proportions voisines de 50% pour chaque composant, cet alliage présentant une excellente tenue aux chocs thermiques et une tension de bruit pratiquement nulle.

A la fréquence de 55 Hz et aux températures de 4°K et de 290°K, les bruit, tension et courant de décalage non compensés, ramenés à l'entrée du dispositif, sont les suivants :

| Nature du signal | à 4°K | à 290°K |
|---|---|---|
| bruit | 0,1 nV/(Hz)1/2 | 0,8 nV/(Hz)1/2 |
| tension de décalage | 3 nV | 8 nV |
| courant de décalage | 300 pA | 2 nA |

Le courant de décalage dû pour l'essentiel à la capacité d'entrée des transistors à effet de champ est sensiblement proportionnel à la fréquence de fonctionnement. Ce courant étant donc constant, il est facile de le compenser par un circuit approprié. Il en est de même pour la tension de décalage.

On conçoit donc que le hâcheur selon l'invention utilise des transistors à l'arséniure de gallium et un matériau amorphe pour le circuit magnétique du transformateur et que le boitier est rempli de matériau d'isolation se présentant par exemple sous la forme de microbilles. Il est à noter qu'une poudre isolante peut également être utilisée.

Cet ensemble de caractéristiques confère au dispositif de conversion selon l'invention, un certain nombre d'avantages, parmi lesquels de faibles signaux de décalage à l'entrée, un faible microphonisme, un faible bruit et un fonctionnement sur une plage étendue de température de 1 à 300°K.

Cette dernière propriété est particulièrement intéressante, car elle permet à ce dispositif de construction simple et de coût relativement bas, d'assurer :
- à température ambiante, un service avantageusement comparable à celui des meilleurs microvoltmètres classiques de laboratoire dont la résolution ne descend pas en-dessous de 10⁻⁸ volt.A cette même température, les sources de bruit de ce nouveau type de hâcheur, qui sont essentiellement liées à l'effet thermo-électrique des fils de liaison et au courant de bruit des transistors à effet de champ, limitent son pouvoir de résolution à 10⁻⁹ volt.
- à très basse température, un service comparable à celui des dispositifs à SQUID mentionnés précédemment, dont la sensibilité est de l'ordre de 10⁻¹² volt, mais dont le coût est beaucoup plus élevé et d'une mise en oeuvre beaucoup plus délicate.

Bien entendu d'autres températures du boîtier peuvent être utilisées comme par exemple une température inférieure ou égale à 77°K dans le cas où la source de réfrigération est une source d'azote liquide.

## Revendications

1. Dispositif de conversion d'un signal de tension continue de très faible amplitude en signal de tension alternative, du type comportant un transformateur à point milieu (1) associé à un hâcheur (2) à transistors (3,4), caractérisé en ce que le transformateur (1) et les transistors (3,4) sont disposés dans une partie (17) d'un boîtier (15) maintenue à très basse température et dans laquelle est disposé un matériau (20) d'isolation thermique des transistors (3,4) afin de réduire les fluctuations de température et permettre le fonctionnement de ces transistors (3,4) par auto-échauffement dû à leur courant de commande.

2. Dispositif selon la revendication 1, caractérisé en ce que la température de cette partie (17) du boîtier est inférieure ou égale à 77°K.

3. Dispositif selon la revendication 2, caractérisé en ce que la température de cette partie (17) du boîtier est inférieure ou égale à 4,2°K.

4. Dispositif selon l'une quelconque des revendications précédentes, caractérisé en ce que les transistors (3,4) sont des transistors à effet de champ.

5. Dispositif selon la revendication 4, caractérisé en ce que les transistors à effet de champ (3,4) sont à l'arséniure de gallium.

6. Dispositif selon l'une quelconque des revendications précédentes, caractérisé en ce que les soudures de liaison des composants du dispositif sont réalisées à l'aide d'un alliage indium/plomb.

7. Dispositif selon l'une quelconque des revendications précédentes, caractérisé en ce que le boîtier (15) est en matériau conducteur de l'électricité supraconducteur.

8. Dispositif selon l'une quelconque des revendications précédentes, caractérisé en ce que le matériau d'isolation (20) est formé de microbilles en verre.

## Patentansprüche

1. Vorrichtung zum Umwandeln eines Gleichspannungssignals mit sehr geringer Amplitude in ein Wechselspannungssignal, mit einem Transformator (1) mit Mittenanschluß, der einem Zerhacker (2) mit Transistoren (3, 4) zugeordnet ist,
**dadurch gekennzeichnet, daß**
der Transformator (1) und die Transistoren (3, 4) in einem Bereich (17) eines Gehäuses (15) angeordnet sind, der auf sehr tiefer Temperatur gehalten wird und in dem ein Isoliermaterial (20) für die Wärmeisolierung der Transistoren (3, 4) angeordnet ist, um die Temperaturschwankungen zu verringern und das Funktionieren der Transistoren (3, 4) aufgrund von Selbsterwärmung durch ihren Steuerstrom zu ermöglichen.

2. Vorrichtung nach Anspruch 1, dadurch gekennzeichnet, daß die Temperatur dieses Bereichs (17) des Gehäuses (15) 77 K oder weniger beträgt.

3. Vorrichtung nach Anspruch 2, dadurch gekennzeichnet, daß die Temperatur dieses Bereichs (17) des Gehäuses (15) 4,2 K oder weniger beträgt.

4. Vorrichtung nach einem der vorhergehenden Ansprüche, dadurch gekennzeichnet, daß die Transistoren (3, 4) Feldeffekttransistoren sind.

5. Vorrichtung nach Anspruch 4, dadurch gekennzeichnet, daß die Feldeffekttransistoren (3, 4) Galliumarsenidtransistoren sind.

6. Vorrichtung nach einem der vorhergehenden Ansprüche, dadurch gekennzeichnet, daß die Verbindungslötungen der Bauelemente der Vorrichtung mit einer Indium-Blei-Legierung hergestellt sind.

7. Vorrichtung nach einem der vorhergehenden Ansprüche, dadurch gekennzeichnet, daß das Gehäuse (15) aus elektrisch supraleitfähigem Material besteht.

8. Vorrichtung nach einem der vorhergehenden Ansprüche, dadurch gekennzeichnet, daß das Isoliermaterial (20) aus Mikrokugeln aus Glas gebildet ist.

## Claims

1. Device for converting a d.c voltage signal of very low amplitude into an a.c voltage signal, of the type comprising a transformer with a centre point (1) associated with a chopper (2) having transistors (3,4), characterised in that the transformer (1) and the transistors (3,4) are arranged in a part (17) of a casing (15) kept at very low temperature, in which is placed a material (20) for thermally insulating the transistors (3,4) in order to reduce temperature fluctuations and allow these transistors (3,4) to operate by self-heating caused by their control current.

2. Device according to claim 1, characterised in that the temperature of this part (17) of the casing is below or equal to 77K.

3. Device according to claim 2, characterised in that the temperature of this part (17) of the casing is below or equal to 4,2K.

4. Device according to any one of the preceding claims, characterised in that the transistors (3,4) are field effect transistors.

5. Device according to claim 4, characterised in that the field effect transistors (3,4) contain gallium arsenide.

6. Device according to any one of the preceding claims, characterised in that the connecting welds between the components of the device are produced by means of an indium/lead alloy.

7. Device according to any one of the preceding claims, characterised in that the casing (15) consists of a superconducting material.

8. Device according to any one of the preceding claims, characterised in that the insulating material (20) is formed from miniature glass beads.
